(19) Europäisches Patentamt
European Patent Office
Office européen des brevets

(11) **EP 2 741 889 B1**

(12) **EUROPEAN PATENT SPECIFICATION**

(45) Date of publication and mention
of the grant of the patent:
**05.05.2021 Bulletin 2021/18**

(21) Application number: **12762677.8**

(22) Date of filing: **08.08.2012**

(51) Int Cl.:
*B23K 35/28* (2006.01)    *B32B 15/01* (2006.01)
*C22C 21/02* (2006.01)    *C22C 21/10* (2006.01)
*B23K 1/00* (2006.01)    *C22C 9/00* (2006.01)
*C22C 9/02* (2006.01)    *C22C 9/06* (2006.01)
*H01L 21/48* (2006.01)    *H01L 23/473* (2006.01)
*C22C 21/00* (2006.01)

(86) International application number:
**PCT/IB2012/001527**

(87) International publication number:
**WO 2013/021266 (14.02.2013 Gazette 2013/07)**

(54) **COOLER FOR HEAT-GENERATING DEVICE, AND METHOD OF PRODUCING COOLER FOR HEAT-GENERATING DEVICE**

KÜHLER FÜR EINE WÄRMEERZEUGENDE VORRICHTUNG UND VERFAHREN ZUR HERSTELLUNG DES KÜHLERS FÜR EINE WÄRMEERZEUGENDE VORRICHTUNG

REFROIDISSEUR POUR DISPOSITIF GÉNÉRANT DE LA CHALEUR ET PROCÉDÉ DE FABRICATION D'UN REFROIDISSEUR POUR DISPOSITIF GÉNÉRANT DE LA CHALEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.08.2011 JP 2011174193**

(43) Date of publication of application:
**18.06.2014 Bulletin 2014/25**

(73) Proprietor: **Toyota Jidosha Kabushiki Kaisha
Toyota-shi, Aichi 471-8571 (JP)**

(72) Inventors:
• **KURODA, Shu
Susono-shi
Shizuoka 410-1127 (JP)**
• **YOSHINO, Michihide
Susono-shi
Shizuoka 410-1127 (JP)**
• **OHNO, Kazutaka
Toyota-shi
Aichi-ken 471-8571 (JP)**
• **FUKAMI, Tomo
Toyota-shi
Aichi-ken 471-8571 (JP)**
• **SUGINO, Yuji
Kariya-City
Aichi-Pref 448-8661 (JP)**

(74) Representative: **Cabinet Beau de Loménie
158, rue de l'Université
75340 Paris Cedex 07 (FR)**

(56) References cited:
EP-A1- 2 075 083    EP-A1- 2 243 589
JP-A- 2000 190 089    JP-A- 2000 309 837
JP-A- 2008 303 405    US-A- 4 560 625
US-A1- 2009 020 585    US-A1- 2009 020 585
US-A1- 2009 165 901    US-A1- 2009 165 901
US-A1- 2010 180 441    US-A1- 2010 180 441
US-A1- 2011 014 494    US-A1- 2011 014 494

**Description**

BACKGROUND OF THE INVENTION

1. Field of the Invention

The invention relates to a clad material for a cooler, used in a cooler that is mounted in an electric automobile or a hybrid automobile, or on any of various electronic device circuits, and cools a heat-generating device such as a semiconductor device. The invention further relates to a cooler for a heat-generating device in which the clad material for a cooler is used, and also relates to a method of producing a cooler for a heat-generating device.

2. Description of Related Art

Coolers that cool heat-generating devices such as semiconductor devices are mounted in electric automobiles or hybrid automobiles, or on various electronic device circuits. A so-called water-cooled cooler is available, in which a top sheet formed of an aluminum alloy sheet to which the cooling target is attached, a bottom sheet of an aluminum alloy sheet, which defines a cooling water passage between the bottom sheet and the top sheet, and an inner fin held between these aluminum alloy sheets, are brazed together and the cooling target is cooled by heat exchange between the cooling target and cooling water flowing within the cooling water passage. In order to raise the efficiency of heat exchange between the cooling water and the cooling target in this cooler, the top sheet, to which to attach the cooling target, is configured to be sufficiently thinner than the bottom sheet. Coolers of this type have also been developed in recent years in which an insulating circuit substrate (the cooling device substrate), to which the semiconductor device (cooling target) is bonded, is attached to the top sheet. This insulating circuit substrate has a metal sheet, e.g., pure aluminum, bonded on each side of a thermally conductive insulating ceramic, e.g., AlN or $Si_3N_4$, and has a function of insulating the semiconductor device from the top sheet while carrying out cooling by conducting the heat produced by the semiconductor element to the top sheet.

The heightened environmental awareness of recent years has resulted in efforts to reduce the weight of automobiles, and a thinning down of the various structural members is thus also underway for the coolers mounted in automobiles. On the other hand, the amount of heat generated by, for example, semiconductor devices, has grown, which has caused an even larger cooling performance to be required of the coolers that cool such semiconductor devices. Under such circumstances, a cooler structure is available, as described in Japanese Patent Application Publication No. 2010-16295 (JP-2010-16295 A), in which a semiconductor device is mounted via a metal sheet onto a thin plate-form heat sink and abutting thereto and this heat sink is divided into a plurality of coolant passages by partition walls.

A cooling water flow is required in order to increase the cooling performance of this type of cooler. However, when a cooling water flow is present, the constituent members of the cooler experience a severely corrosive environment, and, in the particular case of a thinned down top sheet, the corrosion penetrates the sheet in the thickness direction from the cooling water passage side and corrosion pitting rapidly occurs. Due to this, it becomes necessary in particular to improve the corrosion resistance of the top sheet in order to simultaneously achieve an improved cooling performance and thinning down of the cooler.

However, in the case of the materials used for the top sheet in conventional coolers, achieving a balance with the formability makes it difficult to improve the corrosion resistance. In fact, there is a room for improvement of the corrosion resistance of a thin top sheet in the case of a structure that involves cooling water flow. Specifically, in a cooler as described above, for example, a clad material provided by cladding at least one side (surface that becomes the cooling water passage side) of an aluminum alloy sheet with an Al-Si brazing filler metal, is used as the material of the top sheet, and this is press-formed into a prescribed shape to be used for the top sheet. The Japanese Industrial Standards (JIS)-specified O (temper designation) material provided by annealing a wrought material is used for the clad material because it has properties adapted for press forming, such as a large elongation and a low strength.

Here, the core material undergoes recrystallization in the heating process associated with brazing during the production of a cooler that uses a clad material. When the clad material is an O material, the recrystallization is incomplete in regions where there is little working due to the press forming of the clad material and subgrains remain. As a consequence, the molten brazing filler metal then preferentially penetrates into the subgrain boundaries and so-called erosion occurs.

When the brazing filler metal erodes the core material, a portion of this brazing filler metal is consumed and the amount of brazing filler metal furnished to brazing with the bottom sheet and inner fin then becomes inadequate and an adequate joint strength is not obtained. In addition, since corrosion from the cooling water passage side of the top sheet proceeds preferentially from the brazing filler metal composition, there is a risk that corrosion will proceed rapidly in the depth direction when the core material is eroded by the brazing filler metal. Moreover, even when, by the addition of, e.g., Zn, to the brazing filler metal, a structure is elaborated that provides the function of a sacrificial anticorrosion layer, a satisfactory anticorrosion effect has not been obtained and obtaining an excellent corrosion resistance has been difficult.

A top sheet material has also been proposed in the form of an O material with a three layer structure provided by cladding a sacrificial anticorrosion material on one side of the core material (surface that forms the cooling water passage side) and cladding the other side with a brazing filler metal. However, even with a clad material with this structure, the brazing filler metal clad on the other side erodes the core material and as a consequence corrosion proceeds rapidly at locations where the corrosion developing in the depth direction from the cooling water passage side reaches the braze erosion regions from the other side; there is then a risk that corrosion pitting will rapidly occur. Thus, when an O material is used as the top sheet material, an excellent press formability is obtained, but it is difficult to raise the corrosion resistance of the top sheet.

In addition to O materials, a variety of aluminum alloy clad materials are also used as top sheet materials, but all of these are quite susceptible to the occurrence of corrosion pitting for the following reason. Specifically, during cooler production, brazing is preceded by a temporary joining step in which the joint regions of the individual members are temporarily joined to each other. For example, after the insulating circuit substrate has been temporarily joined by laser welding to the top sheet provided by press forming, the top sheet, bottom sheet, and inner fin are assembled and their joint regions are temporarily joined by laser welding.

Here, when the weld area is broadened due to an overly large heat input by this laser welding, corrosion easily occurs because this weld area is electrochemically base, causing the occurrence of corrosion pitting. To avoid this, the amount of heat input must be made as small as possible, but since the surface of the material reflects the laser in the case of aluminum alloys, the material abruptly melts in the initial stage of welding and the amount of heat introduction can easily become overly large. As a consequence, when an aluminum alloy clad material is used as the top sheet, the rapid occurrence of corrosion pitting is a risk due to corrosion in the depth direction from regions welded by laser welding. US 2011/014494 A1, US 2009/020585 A1 and US 2009/165901 A1 disclose examples of aluminum alloy clad sheets for a heat exchanger.

## SUMMARY OF THE INVENTION

The invention provides a cooler for a heat-generating device, wherein this cooler uses this clad material for a cooler, and provides a method of producing this cooler for a heat-generating device.

As a result of investigations directed to improving the press formability, brazing capability, and corrosion resistance of the clad material used as a top sheet material, the inventors obtained the knowledge that these properties are all simultaneously improved by specifying the finish rolling ratio and several properties before and after brazing. The invention has been achieved based on this knowledge and is defined in the appended claims.

According to the invention, the clad material for a cooler has an excellent press formability and can be pressformed into the shape of the top sheet at an excellent accuracy and precision, because the clad material for a cooler is prepared by rolling, at a finish rolling ratio of 10 to 25%, a clad raw material that has a three layer structure of a core material, a first brazing filler metal layer or a sacrificial layer that covers one side (the surface on a fluid passage side) of this core material, and a brazing filler metal layer that covers the other side, and because prescribed ranges are specified for certain properties before and after brazing.

Moreover, with this clad material for a cooler, the heat input-induced welding area can be kept small during the step of providing temporary joints by laser welding, while recrystallization of the core material can be reliably brought out - in both regions of little press forming-induced working and regions of large press forming-induced working - during the heating process during brazing. As a consequence, this clad material for a cooler makes possible an inhibition of erosion of the core material by the brazing filler metal and enables the brazing filler metal to be furnished in satisfactory amounts to brazing between joint regions. In addition, this clad material for a cooler exhibits a potential gradient in the vicinity of the surface on the fluid passage side, and this exhibits a corrosion-preventing effect due to a sacrificial anode effect. Accordingly, the corrosion caused by the laser weld regions and brazing filler metal erosion is inhibited and an excellent corrosion resistance is obtained for the top sheet of the cooler.

According to the invention, the cooler for a heat-generating device uses this clad material for a cooler for its top sheet material, brazing is reliably executed between the joint regions of the various members that constitute the cooler and between the top sheet and the cooling device substrate, while corrosion at the top sheet caused by laser weld regions and brazing filler metal erosion is inhibited, thereby providing an excellent corrosion resistance. As a consequence, the occurrence of corrosion pitting is inhibited even in the case of a high velocity cooling water flow and an even greater improvement in the cooling performance can then be brought about.

## BRIEF DESCRIPTION OF THE DRAWINGS

Features, advantages, and technical and industrial significance of embodiments of the invention will be described below with reference to the accompanying drawings, in which like numerals denote like elements, and wherein:

 FIG. 1 is a schematic cross-sectional diagram that shows a first embodiment of a cooler for a heat-generating device, which uses a clad material for a cooler according to the invention; and
 FIG. 2 is a schematic cross-sectional diagram that shows an example of a clad material for a cooler, which is used as a material of a top sheet in the cooler for a heat-generating device shown in FIG. 1.

DETAILED DESCRIPTION OF EMBODIMENTS

Specific embodiments of the invention will be described herebelow.

<First unclaimed embodiment >

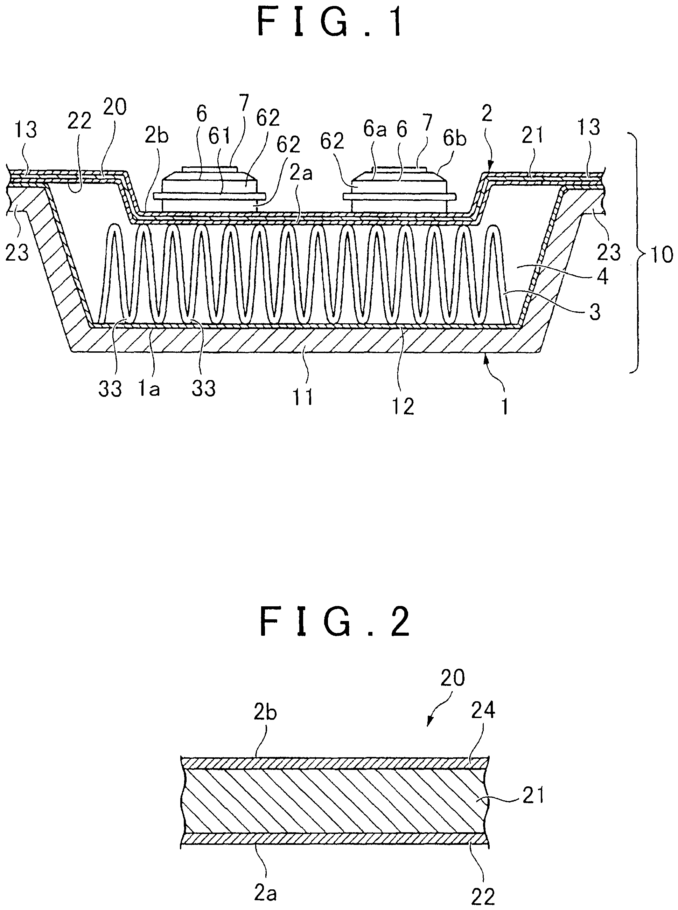

A first embodiment of a cooler for a heat-generating device, which uses a clad material for a cooler according to the invention, will be described first. FIG. 1 is a schematic cross-sectional diagram that shows the first embodiment of a cooler for a heat-generating device, which uses a clad material for a cooler according to the invention. FIG. 2 is a schematic cross-sectional diagram that shows an example of a clad material for a cooler, which is used as the material of the top sheet in the cooler for a heat-generating device shown in FIG. 1.

The cooler 10 for a heat-generating device (referred to below simply as a "cooler"), shown in FIG. 1, is constructed by stacking a bottom sheet 1, which has a shape in which a plurality of sections processed to have a trough-shaped cross section are connected in the lateral direction, an inner fin 3, which resides in the trough-shaped section of the bottom sheet 1, and a top sheet 2 in the given sequence and, using the brazing filler metal layers 12, 22 respectively possessed by the bottom sheet 1 and the top sheet 2, brazing the joint regions 13, 23 of the bottom sheet 1 and the top sheet 2 to each other and brazing the inner fin 3 to the surfaces 1a and 2a. A cooling device substrate 6, which is joined to the heat-generating device that is the cooling target, is also brazed to the outside surface (the surface on the opposite side from a cooling water passage 4) 2b of the top sheet 2 in the cooler 10 of this embodiment.

The bottom sheet 1 and the top sheet 2 function as structural members that define the cooling water passage (fluid passage) 4, through which cooling water (coolant) flows. The bottom sheet 1 has a sheet shape and forms a step portion (joint region) 23, which at its outer edges bonds with the joint region 13 of the top sheet 2. The bottom sheet 1 is thicker than the top sheet 2, which is described below, and in specific terms the bottom sheet 1 is about 1.0 to 4.0 mm. The top sheet 2 is a sheet that has a planar shape approximately the same as the bottom sheet 1 and forms a step portion (joint region) 13, which at its outer edges bonds with the joint region 23 of the bottom sheet 1. The top sheet 2 is thinner than the bottom sheet 1, and in specific terms the top sheet 2 is about 0.2 to 2.0 mm. In this embodiment, the material of the top sheet 2 is a clad material 20 for a cooler according to the invention. The structure of this clad material 20 for a cooler will be described below. The bottom sheet 1 and the top sheet 2 are brazed to each other at the step portions 13, 23. A cooling water passage 4, which is sealed by the side walls of the step portions 13 and 23, is defined between the bottom sheet 1 and the top sheet 2.

The inner fin 3 functions as a heat transfer surface that contributes to heat exchange between the cooling water and the heat-generating device. The inner fin 3 has an accordion-like shape and is held within the cooling water passage 4. Each bend (joint region) 33 of the inner fin 3 is brazed to a surface (surface on the cooling water passage side) 1a, 2a of the bottom sheet 1 or the top sheet 2.

The heat-generating device 7, e.g., a semiconductor device, is joined across a solder layer 6b to the surface (surface on the opposite from the top sheet) 6a of the cooling device substrate 6, and the cooling device substrate 6 conducts the heat produced by the heat-generating device 7 to the top sheet 2 while also insulating the heat-generating device 7 from the top sheet 2. Examples of this cooling device substrate include an insulating circuit substrate in which an aluminum layer 62 is bonded on each side of a thermally conductive ceramic 61, e.g., AlN or $Si_3N_4$.

In the cooler 10 of this embodiment, the heat-generating device 7 is cooled via the inner fin 3, top sheet 2, and cooling device substrate 6 by cooling water flowing in the cooling water passage 4.

To produce the cooler 10 of this embodiment, a molding is first obtained by press forming the clad material 20 for a cooler, described below, into the shape of the top sheet (press-forming step). The cooling device substrate 6 is then temporarily joined by laser welding to this molding, and this is followed by the assembly of the molding, the bottom sheet 1, and the inner fin 3 and temporarily joining the joint regions 13, 23, 33 by laser welding (temporary joining step). The molding, the bottom sheet 1, the inner fin 3, and the cooling device substrate 6 are coated with, for example, a fluoride-based flux (for example, a noncorrosive Nocolok flux or Zn substitution flux), and a heat treatment is then carried out in an oven having an inert atmosphere, e.g., a high-purity nitrogen gas atmosphere. The heat treatment temperature is about 590 to 620°C. By doing this, the brazing filler metal layers 12, 22 possessed by the bottom sheet 1 and the clad material 20 for a cooler are melted and flow, and the brazing filler metal is then solidified by reducing the temperature in the oven. As a result, the individual joint regions 13, 23, and 33 become brazed and the outside surface 2b of the top sheet 2 is brazed to the cooling device substrate 6 and the cooler 10 is thereby obtained (brazing step).

The structure of the bottom sheet 1, the top sheet 2, and the inner fin 3 will now be considered.

<Top sheet>

A structure of the top sheet 2 will be described first. A characteristic feature of the cooler 10 of the invention is that the material of the top sheet 2 is the clad material 20 for a cooler according to the invention. That is, the top sheet 2 is provided by forming the clad material 20 for a cooler into the shape of the top sheet and brazing this molding to other members, that is, the bottom sheet 1, the inner fin 3, and the cooling device substrate 6 that constitute the cooler 10.

As shown in FIG. 2, the clad material 20 for a cooler is a clad material provided by executing a strain production of 3 to 10% or rolling at a finish rolling ratio of 10 to 25% on a clad raw material with a three layer structure formed of a core material 21, a first brazing filler metal layer 22 that covers one side (the surface forming the cooling water passage 4 side) of the core material 21, and a second brazing filler metal layer 24 that covers the other side (the surface forming the opposite side from the cooling water passage 4) of the core material 21. Moreover, particular ranges are prescribed for certain properties as described below.

The compositions of the individual parts 21, 22, 24 of the clad material 20 for a cooler will be described below. The core material 21 is formed of an aluminum alloy that contains Mn, Cu, and Si and that contains at least one selected from Fe, Ti, and Zr, with the balance being made of Al and unavoidable impurities. The individual component contents are as follows: Mn : 0.4 to 1.5 mass%, Cu : 0.05 to 0.8 mass%, Si : 0.05 to 1.0 mass%, Fe : 0.05 to 0.5 mass%, Ti : 0.05 to 0.20 mass%, and Zr : 0.05 to 0.15 mass%. The functions of these individual components are as follows.

Mn : Mn precipitates or crystallizes as an intermetallic compound and has a function of improving the post-brazing strength of the top sheet 2. In addition, by forming an Al-Mn-Si compound, it has the effect of lowering the Si solid solubility of the matrix and raising the melting point of the matrix. These effects are not satisfactorily obtained when the Mn content is less than 0.4 mass%. The casting and processing (rolling) characteristics of the clad raw material decline when the Mn content exceeds 1.5 mass%.

Si : Si is present in a solid solution state in the matrix or dispersed as an Al-Mn-Si compound and has a function of improving the strength of the core material 21. This effect is not satisfactorily obtained when the Si content is less than 0.05 mass%. When the Si content exceeds 1.0 mass%, the melting point of the core material 21 declines and the core material 21 may then melt during brazing.

Cu : Cu is present in a solid solution state in the matrix and has a function of raising the strength of the core material 21. In addition, Cu forms a concentration gradient from the core material 21 in the direction of the passage side brazing filler metal, thereby forming a potential gradient that is effective for stopping corrosion and improving the resistance of the clad material to corrosion pitting. These effects are not satisfactorily obtained when the Cu content is less than 0.05 mass%. When the Cu content exceeds 0.8 mass%, Cu that has diffused to the brazing filler metal surface causes the potential of the brazing filler metal to be noble (high), which diminishes the sacrificial anode effect of the potential gradient layer, resulting in a loss of its anticorrosion activity. In addition, when the Cu content is too high, the melting point of the core material 21 is reduced and the core material 21 may then melt during brazing.

Fe : Fe precipitates or crystallizes as an intermetallic compound and has a function of increasing the post-brazing strength of the top sheet 2. In addition, by forming an Al-Mn-Fe, Al-Fe-Si, or Al-Mn-Fe-Si compound, Fe has the effect of lowering the Mn and Si solid solubility in the matrix and raising the melting point of the matrix. These effects are not satisfactorily obtained when the Fe content is less than 0.05 mass%. The corrosion rate of the core material 21 is sped up when the Fe content exceeds 0.5 mass%. A very large crystalline material also appears, which causes a decline in the casting and rolling characteristics of the clad raw material. Fe at less than 0.05 mass% is regarded as an unavoidable impurity.

Ti, Zr : Ti and Zr are dispersed as microscopic intermetallic compounds after brazing and have a function of improving the strength of the top sheet 2. This effect is not satisfactorily obtained when their content is less than 0.05 mass%. In addition, the processability and resistance to self-corrosion of the core material 21 decline when the Ti content exceeds 0.20 mass% or when the Zr content exceeds 0.15 mass%. Ti at less than 0.05 mass% and Zr at less than 0.05 mass% are regarded as unavoidable impurities.

The first brazing filler metal layer 22 supplies brazing filler metal that brazes the joint region 13 of the clad material 20 (top sheet 2) for a cooler to the joint region 23 of the bottom sheet 1 and that brazes the surface 2a of the clad material 20 (top sheet 2) for a cooler to the bends 33 of the inner fin 3. This first brazing filler metal layer 22 is formed of an aluminum alloy brazing filler metal that contains Si and Zn with the balance being made of Al and unavoidable impurities. The Si and Zn contents are Si : 4.5 to 11.0 mass% and Zn : 0.5 to 5.0 mass%, and the function of each of these components is as follows.

Si : Si is melted and flows due to the heat treatment in the brazing step, and through its subsequent solidification brazes the joint regions 13, 23 to each other and brazes the surface 2a of the top sheet 2 to the bends 33 of the inner fin 3. Si also has a function of lowering the melting point of the brazing filler metal and a function of raising its fluidity when it is molten. The brazing capability is inadequate when the Si content is less than 4.5 mass%. When the Si content exceeds 11.0 mass%, Si then engages in substantial erosion of the core material 21 or the bonding members 1, 3.

Zn : Zn diffuses into the core material 21 due to the heat treatment accompanying the brazing step and forms a Zn concentration gradient in the depth direction from the surface 2a of the clad material 20 (top sheet 2) for a cooler. Since Zn has a relatively lower potential (lower ionization energy), the formation of such a concentration gradient produces a potential gradient in the depth direction from the surface 2a of the top sheet 2. In the case of a top sheet 2 in which such a potential gradient layer has been formed, its sacrificial anode effect causes cooling water-induced corrosion to proceed preferentially in the surface direction and the development of corrosion in the depth direction is inhibited. The occurrence of corrosion pitting can be inhibited as a result. A satisfactory potential gradient is not formed when the Zn content is less than 0.5 mass%. When the Zn content exceeds 5.0 mass%, the self-corrosion rate of the potential gradient layer will be too high and corrosion in the depth direction of the top sheet 2 cannot be satisfactorily inhibited.

The second brazing filler metal layer 24 furnishes brazing filler metal that brazes the cooling device substrate 6 to the outside surface 2b of the top sheet 2. This second brazing filler metal layer 24 is formed of an aluminum alloy brazing filler metal that contains 6.5 to 12.6 mass% of Si with the balance being Al and unavoidable impurities. The brazing capability is inadequate when the Si content is less than 6.5 mass%. When the Si content exceeds 12.6 mass%, coarse Si grains appear and the rollability is reduced, while substantial erosion of the core material 21 or the cooling device substrate 6 also occurs.

The clad raw material of the clad material 20 for a cooler, the strain production, and the rolling process will now be considered. This clad material 20 for a cooler is provided by executing a 3 to 10% strain production or rolling at a finish rolling ratio of 10 to 25% on a clad raw material that has a three layer structure with the previously described composition. The execution of such a rolling step makes it possible, when the clad material 20 for a cooler is subjected to the press forming and brazing steps, to reliably bring about recrystallization in the associated heating process of the core material in both regions of little press forming-induced working and regions of large press forming-induced working. As a consequence, the erosion in which molten brazing filler metal penetrates into the core material is inhibited and an adequate amount of brazing filler metal can be supplied to brazing between the joint regions 13, 23, to brazing between the surface 2a and the bends 33 of the inner fin 3, and to brazing between the outside surface 2b and the cooling device substrate 6. In addition, the development in the top sheet 2 of corrosion caused by braze erosion of the core material 21 is inhibited and an excellent resistance to corrosion pitting can then be obtained. The strain production here is a step in which a tensile strain is produced in the direction parallel to the rolling direction of the material, and the production is carried out industrially with, for example, a tension leveler. The strain production ratio is the elongation ratio of the material.

Here, the clad raw material preferably is annealed, prior to finish rolling, by heating to a temperature within a range from 300 to 550°C at a rate of temperature rise of 100 to 10,000°C/minute, keeping at the temperature for 1 second to 4 hours, and then cooling and is thereafter subjected to a 3 to 10% strain production or a 10 to 25% rolling. This can make fine the crystal grains of the core material and thereby makes it possible to obtain an excellent press formability. In addition, by also carrying out a heat treatment by keeping for 1 to 8 hours at a temperature within a range from 150 to 400°C after the 3 to 10% strain production or after the 10 to 25% rolling, penetration of the molten brazing filler metal into the core material as described above can be inhibited while the press formability is also improved still further. An improvement in the formability is not obtained at temperatures less than 150°C. At temperatures above 400°C, erosion of the core material by molten braze becomes severe in those regions subjected to working during press forming, resulting in a decline in brazing capability and a loss of corrosion resistance. The desired effect is not obtained when the heat treatment time is less than 1 hour, while the effect levels off above 8 hours.

The properties prescribed for this clad material 20 for a cooler will now be described. The pre-brazing properties prescribed for this clad material 20 for a cooler are the elongation, the average crystal grain diameter of the core material 21, and the average grain diameter (equivalent circle diameter) of the Si grains present in the brazing filler metal layers 22 and 24, while the post-brazing properties prescribed for this clad material 20 for a cooler are the potential difference between the core material 21 and the surface 2a of the first brazing filler metal layer 22 and the proportion taken up by the core material 21 in the total thickness of the clad material for a cooler. Here, the post-brazing properties of the clad material 20 for a cooler correspond to the properties of the top sheet 2 in the cooler 10.

(1) The pre-brazing properties

A. The pre-brazing elongation and the average crystal grain diameter of the core material before brazing

A pre-brazing elongation of at least 10% is prescribed for the clad material 20 for a cooler and an average crystal grain diameter of 10 to 100 $\mu$m is prescribed for the core material 21 before brazing. As described above, a rolling process is executed on the clad material 20 for a cooler. Here, the strength may be increased when the rolling process is executed and the press formability may be impaired as a result; however, when the elongation and the average crystal grain diameter in the core material 21 are in the indicated ranges, an excellent formability is obtained and the top sheet shape can be formed with an excellent accuracy and precision even when a rolling process is implemented. The average crystal grain diameter was measured in the invention as follows: a section parallel to the rolling direction was polished and electrolytically etched using, for example, Barker's solution; the crystal structure was observed and the crystal structure was photographed; and measurement was carried out by the "line intercept method" described in JIS G 0551.

Due to the small elongation, a clad material with an elongation below 10% cannot be molded due to the production of cracks when press forming is carried out. While there are no particular limitations on the upper limit for the elongation, the elongation is preferably not more than 35%. The press formability of the clad material does tend to increase as the elongation increases, but this effect levels off when the elongation exceeds 35%.

An acceptable press formability is not obtained and cracks are produced during the press-forming step when the average crystal grain diameter of the core material 21 exceeds 100 $\mu$m. While the press formability of the clad material does improve as the average crystal grain diameter of the core material 21 declines, this effect is saturated when the average crystal grain diameter is less than 10 $\mu$m.

B. The pre-brazing average grain diameter (equivalent circle diameter) of the Si grains present in the brazing filler metal layers.

The average grain diameter (equivalent circle diameter) of the Si grains present in the brazing filler metal layers 22 and 24 before brazing is set at less than 1.8 $\mu$m. This slows the incidence of the laser at the brazing filler metal layers 22, 24 in the temporary joining step by laser welding and facilitates control of the amount of heat input thereby, and as a consequence the welded region can be kept small. As a result, the generation of corrosion from the weld region is inhibited in the top sheet 2 of the obtained cooler 10 and the occurrence of corrosion pitting caused by the development of corrosion from the weld region can be stopped. In addition, because the Si grains with an average grain diameter of less than 1.8 $\mu$m are fine, melting of the brazing filler metal layers 22, 24 as a whole proceeds uniformly. This improves the brazing capability and to inhibit the occurrence of brazing defects, such as voids, in particular when the top sheet 2 is brazed to the cooling device substrate 6. The average grain diameter of the Si grains was measured in the invention as follows: a section parallel to the rolling direction was polished; etching was performed with 0.5% HF (hydrofluoric acid); the Si grains were observed and photographed; and the equivalent circle diameter was measured using an image analyzer. The amplification factor was 100X and the average for 10 fields of vision was measured.

When the average grain diameter of the Si grains present in the brazing filler metal layers 22, 24 is larger than 1.8 $\mu$m, heat input to the brazing filler metal layers 22, 24 proceeds rapidly during laser welding and the melted area then increases. This results in the appearance of the following problems: corrosion develops from the weld region in the top sheet 2 of the obtained cooler 10 and corrosion pitting occurs; the clearance between the top sheet 2 and the cooling device substrate 6 also increases and the heat exchange efficiency declines; and the amount of brazing filler metal at the brazing filler metal layers 22, 24 falls short and a satisfactory brazing capability is not obtained. There are no particular limitations on the lower limit of the average grain diameter of the Si grains, but at least 0.5 $\mu$m is preferred. The above-described effects of relaxing the laser incidence and improving the brazing capability do tend to increase as the average grain diameter of the Si grains becomes finer, but these effects level off when the average grain diameter of the Si grains falls below 0.5 $\mu$m.

(2) The post-brazing properties

C. The post-brazing potential difference between the core material and the surface of the first brazing filler metal layer

A value of at least 50 mV is specified for the potential difference after brazing between the core material 21 and the surface 2a of the first brazing filler metal layer 22. When the clad material 20 (top sheet 2) for a cooler exhibits such a potential difference (potential gradient), a sacrificial anode effect is obtained in the vicinity of the surface 2a and the development of corrosion in the depth direction is inhibited. The occurrence of corrosion pitting can be inhibited as a consequence. When the potential difference is less than 50 mV, this sacrificial anode effect is not obtained and the inhibition of corrosion in the depth direction is not obtained. There are no particular limitations on the upper limit for the potential difference, but this potential difference is preferably not more than 300 mV. While the corrosion-preventing effect provided by the potential gradient does tend to increase as this potential difference increases, an additional effect is not obtained for a potential difference in the range above 300 mV, while drawbacks such as an overly fast corrosion rate do appear. To measure this potential difference, the pitting potential is measured by carrying out an anodic polarization measurement at 40°C using a 2.67% $AlCl_3$ solution and a potential sweep rate of 0.5 mV/s. With respect to the core material, the potential is measured in the vicinity of the central part of the sheet after performing etching at 50°C with 5% NaOH.

D. The proportion of the core material in the overall thickness after brazing

The proportion $t_1/T$ (%) of the thickness of the core material 21 in the total thickness after brazing must satisfy the following Expression.

$t_1/T$ (%) $\geq$ 85% ... Expression
T : total thickness of the top sheet
$t_1$ : thickness of the core material

The proportion of the core material in the total thickness is measured by polishing a section parallel to the rolling direction, electrolytically etching using Barker's solution, determining the interface between the core material and the brazing filler metal, and measuring. The average position in the visual field is used for the interface, and the average for 10 fields of vision is measured.

Since corrosion of the top sheet 2 readily proceeds at the eutectic regions in the brazing filler metal, corrosion easily proceeds in the depth direction and corrosion pitting rapidly occurs when the proportion (core material cladding ratio) of the brazing filler metal thickness to the core material thickness is large. In contrast, when the proportion of the core material 21 in the total thickness satisfies the prescribed conditional Expression, the proportion of the brazing filler metal thickness to the core material thickness takes on a small value and as a consequence corrosion in the depth direction is inhibited and corrosion pitting can be inhibited.

An excellent press formability can be obtained and an accurate and precise press forming into the shape of the top sheet can be performed because the clad material 20 for a cooler configured as described in the preceding is provided by executing rolling at a finish rolling ratio of 10 to 25% on a clad raw material with a three layer structure formed of a core material 21, a first brazing filler metal layer 22 that covers one side (the surface forming the cooling water passage 4 side) of the core material 21, and a second brazing filler metal layer 24 that covers the other side (the surface forming the opposite side from the cooling water passage 4) of the core material 21 and because particular ranges are prescribed for certain properties before and after brazing.

Moreover, with this clad material 20 for a cooler, because the weld area caused by the heat input in the laser welding temporary joining step is kept small and because recrystallization of the core material 21 can be reliably brought out - in both regions of little press forming-induced working and regions of large press forming-induced working - during the heating process during the brazing step, erosion of the core material 21 by the brazing filler metal can be inhibited and an adequate amount of brazing filler metal can be supplied to brazing between the joint regions 13, 23, to brazing between the surface 2a and the bends 33 of the inner fin 3, and to brazing between the outside surface 2b and the cooling device substrate 6. In addition, a potential gradient is present in the vicinity of the surface 2a and this exhibits an anticorrosion action due to a sacrificial anode effect. As a consequence, the development of corrosion caused by the laser weld region and by brazing filler metal erosion can be inhibited and an excellent corrosion resistance is obtained for the top sheet 2 of the cooler 10.

<Bottom sheet>

A clad material or a bare material as ordinarily used in coolers 10 of this type can be used for the bottom sheet 1. Specific examples are provided below. As shown in FIG. 1, a clad material can be used that has a core material 11 and a brazing filler metal layer 12 that covers one side (the surface forming the cooling water passage 4 side) of this core material 11, for example.

An aluminum alloy, such as an Al-Mn alloy or an Al-Mn-Cu alloy, can be used as the constituent material of the core material, and JIS 3203 alloy and JIS 3003 alloy are specific examples. The component contents in these aluminum alloys are preferably Mn : 1.0 to 1.5 mass% and Cu : 0.1 to 0.7 mass%. Examples of the brazing filler metal of the brazing filler metal layer include aluminum alloy brazing filler metals such as Al-Si-Zn alloy brazing filler metals, and preferred component contents here are Si : 4 to 11 mass% and Zn : 0 to 5 mass%.

When the inner fin 3 has a brazing filler metal layer, a bare material without a cladding layer can be used or a clad material having a core material and a sacrificial material layer coating one side (the surface forming the cooling water passage 4 side) of this core material can be used. The constituent material of this bare material or of the core material of the sacrificial material layer-bearing clad material may be the same constituent materials as those for the core material of the brazing filler metal layer-bearing clad material described above. Examples of the sacrificial material in the sacrificial material layer include aluminum alloys such as Al-Zn alloys, wherein the Zn content is preferably 0 to 5 mass%. The Al-Zn alloy may optionally contain Mn, Si, or Fe.

<Inner fin>

A bare fin material or a clad fin material as ordinarily used in coolers 10 of this type can be used for the inner fin 3. Specific examples are given below. Examples of the bare fin material include bare fin materials formed of an aluminum alloy and bare fin materials formed of pure aluminum.

The aluminum alloy can be, for example, an Al-Mn alloy, Al-Mn-Cu alloy, Al-Mn-Zn alloy, or Al-Mn-Cu-Zn alloy, and specific examples are JIS 3003 alloy and JIS 3203 alloy. These aluminum alloys may contain Zn at a content of 0.5 to 3.0 mass%. In addition, an Al-Zn alloy may be used, and its Zn content is preferably 0.5 to 2.0 mass%. Examples of the pure aluminum include JIS 1050, JIS 1100, and JIS 1200.

A clad fin material can be used that has a core material and a brazing filler metal layer that covers at least one side of the core material. Pure aluminum or the same aluminum alloys as those for the bare fin material can be used as the constituent material of the core material. The constituent material of the brazing filler metal layer may be, for example, the same aluminum alloy brazing filler metals as those for the brazing filler metal layers of the previously described bottom sheet 1.

The cooler 10 structured as described above uses as the top sheet 2 a clad material 20 for a cooler that is provided by executing rolling at a finish rolling ratio of 10 to 25% on a clad raw material having a three layer structure formed of a core material 21, a first brazing filler metal layer 22 that covers one side (the surface forming the cooling water passage 4 side) of the core material 21, and a second brazing filler metal layer 24 that covers the other side (the surface forming the opposite side from the cooling water passage 4) of the core material 21, and for which particular ranges are prescribed for certain properties before and after brazing, so that reliable and secure brazing between the joint regions 13, 23, between the surface 2a and the bends 33 of the inner fin 3, and between the outside surface 2b and the cooling device substrate 6 are carried out and an excellent corrosion resistance is obtained because the development of corrosion of the top sheet 2 caused by the laser weld regions and/or brazing filler metal erosion is inhibited. As a consequence, the occurrence of corrosion pitting can be inhibited even in the case of a high velocity cooling water flow and a further improvement in the cooling performance can then be brought about.

< The second embodiment >

A second embodiment of a cooler for a heat-generating device (a cooler for a heat-generating device according to the invention) that uses another example of a clad material for a cooler according to the invention. Those structures in the second embodiment that are similar to those of the previously described first embodiment will not be described in detail again. The cooler for a heat-generating device of the second embodiment is similar to the first embodiment, except that there is a change in the structure of the clad material 20 for a cooler used as the material of the top sheet 2.

In this embodiment, the clad material for a cooler has a sacrificial material layer in place of the first brazing filler metal layer 22, while its other elements, i.e., the composition of the core material and the brazing filler metal layer (the second brazing filler metal layer 24 in the first embodiment), the finish rolling ratio, and the pre- and post-brazing properties, are similar to those of the clad material 20 for a cooler of the first embodiment. In this case, the inner fin is a clad material having a core material and a brazing filler metal layer coated on one side (the top sheet side) or both sides of the core material. The structure of this sacrificial material layer is described below.

In the brazing step, the sacrificial material layer forms a potential gradient layer on the cooling water passage side of the clad material 20 (the top sheet 2) for a cooler, and through its sacrificial anode effect imparts corrosion resistance to the top sheet 2. This sacrificial material layer is disposed so as to cover one side (the surface on the cooling water passage 4 side) of the core material 21 and is formed of an aluminum alloy that contains Zn and at least one selected from Si, Fe, Mn, Ti, and Zr, with the balance being made of Al and unavoidable impurities. The contents of the individual components are as follows: Zn : 0.5 to 5.0 mass%, Si : 0.05 to 1.0 mass%, Fe : 0.05 to 0.5 mass%, Mn : 0.05 to 1.1 mass%, Ti : 0.05 to 0.20 mass%, and Zr : 0.05 to 0.15 mass%. The function of each component is as follows.

Zn : Due to the heat treatment accompanying the brazing step, Zn forms a Zn concentration gradient in the depth direction from the surface 2a of the clad material 20 (the top sheet 2) for a cooler. Since Zn has a relatively lower potential (lower ionization energy), the formation of such a concentration gradient produces a potential gradient in the depth direction from the surface 2a of the top sheet 2. In the case of a top sheet 2 in which such a potential gradient layer has been formed, due to its sacrificial anode effect, cooling water-induced corrosion proceeds preferentially in the surface direction and the development of corrosion in the depth direction is inhibited. This results in an inhibition of occurrence of corrosion pitting. A satisfactory potential gradient is not formed when the Zn content is less than 0.5 mass%. Moreover, when the Zn content exceeds 5.0 mass%, the self-corrosion rate of the potential gradient layer will be too high and corrosion of the top sheet 2 in its depth direction cannot be satisfactorily inhibited.

Si, Fe, Mn : These components precipitate or crystallize as intermetallic compounds and have a function of improving the strength, erosion resistance, and corrosion resistance of the top sheet 2 after brazing. These effects are not satisfactorily obtained when the content of a particular component is less than the lower limit. When the content of a particular component exceeds the upper limit, the corrosion rate of the sacrificial material layer is then too high and the corrosion of the core material cannot be adequately inhibited. The unavoidable impurity range is less than 0.05% for each of these elements.

Ti, Zr : These components are dispersed as microscopic intermetallic compounds after brazing and have a function of improving the strength of the top sheet 2. This effect is not satisfactorily obtained when their content is less than 0.05 mass%. In addition, the processability of the sacrificial material layer declines when the Ti content exceeds 0.20 mass% or when the Zr content exceeds 0.15 mass%. Ti less than 0.05 mass% and Zr less than 0.05 mass% are regarded as unavoidable impurities.

As in case of the first embodiment, a value of at least 50 mV is prescribed for the post-brazing potential difference between the core material 21 and the surface of the sacrificial material layer in the structure of the second embodiment. When the clad material 20 (the top sheet 2) for a cooler has such a potential difference (potential gradient), a sacrificial anode effect is obtained in the vicinity of its surface 2a and the development of corrosion in the depth direction is inhibited. The occurrence of corrosion pitting can be inhibited as a result.

This sacrificial anode effect is not obtained when the potential difference is less than 50 mV and the effect of inhibiting the development of corrosion in the depth direction is then not obtained. There are no particular limitations on the upper limit for the potential difference, but this potential difference is preferably not more than 300 mV. While the corrosion-preventing effect provided by the potential gradient does tend to increase as this potential difference increases, an additional effect is not obtained for a potential difference above 300 mV and drawbacks such as an overly fast corrosion rate do appear.

An excellent press formability can be obtained and an accurate and precise press forming into the shape of the top sheet can be performed because the clad material 20 for a cooler configured as described above is provided by executing rolling at a finish rolling ratio of 10 to 25% on a clad raw material having a three layer structure formed of a core material 21, a sacrificial material layer that covers one side (the surface forming the cooling water passage 4 side) of the core material 21, and a brazing filler metal layer that covers the other side (the surface forming the opposite side from the cooling water passage 4) of the core material 21 and because particular ranges are prescribed for certain properties before and after brazing.

Moreover, with this clad material 20 for a cooler, because the weld area caused by the heat input in the laser welding temporary joining step is kept small and because recrystallization of the core material can be reliably brought out - in both regions of little press forming-induced working and regions of large press forming-induced working - during the heating process during the brazing step, erosion of the core material by the brazing filler metal can be inhibited and an adequate amount of brazing filler metal can be supplied to brazing between the outside surface 2b and the cooling device substrate 6. In addition, a potential gradient is present in the vicinity of the surface 2a and this exhibits an anticorrosion action due to a sacrificial anode effect. As a consequence, the development of corrosion caused by the laser weld region and by brazing filler metal erosion can be inhibited and an excellent corrosion resistance is obtained for the top sheet 2 of the cooler 10.

Accordingly, a cooler that uses for the material of its top sheet 2 the above-described clad material 20 for a cooler, exhibits reliable and secure brazing between the top sheet 2 and the cooling device substrate 6 and provides an excellent corrosion resistance due to an inhibition of corrosion of the top sheet 2 caused by the laser weld region and/or brazing filler metal erosion. As a consequence, the occurrence of corrosion pitting can be inhibited even in the case of a high velocity cooling water flow and a further improvement in the cooling performance can then be brought about. Embodiments of the heat exchanger of the invention have been described hereinabove, but these are only examples of the various components that make up this heat exchanger, and these components can be modified as appropriate within a range that does not go beyond the scope of the invention.

Specific examples of the invention are described below, but the invention is not limited to these examples. The bottom sheet used was a clad material (clad thick sheet material) that had the cross-sectional shape shown in FIG. 1; it was prepared by cladding a 150 $\mu$m-thick brazing filler metal layer with the composition shown in Table 1 by pressure-bonding on a 3 mm-thick aluminum alloy core material with the composition shown in Table 1. The top sheet used was a three layer clad material (clad thin sheet material) that had the cross-sectional shape shown in FIG. 1; it was prepared by cladding a 60 $\mu$m-thick brazing filler metal layer (passage side brazing filler metal) with the composition shown in Table 2 by pressure-bonding on one side of a 0.6 mm-thick aluminum alloy core material with the composition shown in Table 2 and cladding a 60-$\mu$m brazing filler metal layer (brazing filler metal on the opposite side from the passage) with the composition shown in Table 2 by pressure-bonding on the other side of the 0.6 mm-thick aluminum alloy core material. The top sheet was press formed into a structure with the cross section shown in FIG. 1: 100 mm × 200 mm, shape = drawn rectangular cup, depth of approximately 2 mm, flange portion = 10 mm. The bottom sheet was press formed into a structure with the cross section shown in FIG. 1: 100 mm × 200 mm, shape = drawn rectangular cup, depth of approximately 10 mm, flange portion = 10 mm. An inner fin with a shape of height 60 mm × width 170 mm was used. The inner fin samples with the compositions shown in Table 3 below were used as the inner fin. The bottom sheet, top sheet, and inner fin were assembled as shown in FIG. 1 and a heat exchanger was produced by performing brazing by raising the temperature at an average rate of temperature rise of 25°C/minute in a high-purity nitrogen gas atmosphere ($O_2$ concentration not more than 20 ppm) and controlling the temperature of the top sheet with the oven set temperature and the holding time varied. A heat exchanger was also produced as described above, using a clad thin sheet material having the inside sacrificial material (passage side sacrificial material) shown in Table 3 in place of the clad thin sheet material shown in Table 2. Corrosion testing was performed on the obtained heat exchangers. In the corrosion test, a corrosion solution prepared by adding NaCl, $Na_2SO_4$, and $CuCl_2$ to ion-exchanged water (Cl⁻: 100 ppm, $SO_4^{2-}$: 300 ppm, Cu⁺⁺: 200 ppm) was used. This was a test in which the flow rate (L/min) was changed in a test in which this corrosion solution was circulated (80°C × 8 h) in the heat exchanger followed by 16 h × room temperature (circulation stopped). The measurement results for each of the following are reported in Tables 4 and 5: the annealing conditions, strain production ratio, elongation, core material grain diameter, Si grain diameter, core material ratio after brazing, potential difference, and the corrosion test. With regard to the strain production ratio given in Table 4, it is indicated that a strain of less than 10% is produced by tensile strain while a strain of 10% or more is produced by rolling. The reason for this is as follows: the rolling load is too low when a strain of less than 10% is produced by rolling and rolling itself is then difficult; the material breaks when a strain of 10% or more is produced by tension. The indicated strain is introduced by tension or rolling as appropriate considering the preceding. Tensile strain production and rolling exhibit the same work hardening characteristics at a working ratio. For example, at a working ratio of not more than 15% (assuming a range in which breakage by tension does not occur), introduction of the strain was carried out assuming the relationship [strength after a 10% tensile strain is applied] = [strength after rolling at a 10% rolling ratio] holds.

Table 1.

|  | core material | | | | | brazing filler metal | |
| --- | --- | --- | --- | --- | --- | --- | --- |
|  | Mn | Cu | Si | Fe | Ti | Si | Zn |
| clad thick sheet material | 1.1 | 0.15 | 0.3 | 0.45 | 0.06 | 7.5 | 3.5 |

Table 2.

| | core material | | | | | | brazing filler metal on the passage side | | brazing filler metal on the opposite side from the passage | |
|---|---|---|---|---|---|---|---|---|---|---|
| | Mn | Cu | Si | Fe | Ti | Zr | Si | Zn | present/ absent | Si |
| | 0.4-1.5 | 0.05-0.8 | 0.05-1.0 | 0.05-0.5 | 0.05-0.20 | 0.05-0.15 | 4.5-11.0 | 0.5-5.0 | | 6.5-1.2.6 |
| Example 1 | 0.42 | 0.7 | 0.15 | 0.21 | 0.15 | 0.1 | 4.5 | 0.7 | present | 10.0 |
| 2 | 0.85 | 0.56 | 0.06 | 0.45 | | | 5.5 | 0.8 | present | 11.5 |
| 3 | 1.0 | 0.5 | 0.18 | | | | 10.3 | 1.5 | present | 9.0 |
| 4 | 1.2 | 0.5 | 0.2 | | 0.17 | | 7.5 | 2.5 | present | 5.3 |
| 5 | 1.2 | 0.12 | 0.05 | | 0.1 | | 7.5 | 3.3 | present | 10.6 |
| 6 | 1.2 | 0.24 | 0.5 | | 0.07 | | 9.3 | 4.8 | present | 10.3 |
| 7 | 1 | 0.08 | 0.6 | | | 0.12 | 10.6 | 3.5 | present | 7.5 |
| 8 | 1.5 | 0.06 | 0.95 | | | 0.14 | 7.5 | 5.8 | present | 8.9 |
| Comparative Example 1 | 0.35∗ | 0.2 | 0.02∗ | 0.32 | | | 7.5 | 0.3∗ | present | 13.0∗ |
| 2 | 1.8∗ | 0.23 | 0.25 | 0.04∗ | | | 7.5 | 6.9∗ | present | 9.0 |
| 3 | 1.3 | 0.02∗ | 0.39 | | | | 4.1∗ | 3.2 | present | 9.4 |
| 4 | 1.2 | 0.92∗ | 1.2∗ | 0.56∗ | 0.26∗ | 0.15 | 12.1∗ | 3.2 | present | 10.3 |
| 5 | 1.1 | 0.17 | 0.23 | 0.32 | | | 4.3∗ | 0.4∗ | present | 10.1 |
| (composition: mass%) | | | | | | | | | | |

EP 2 741 889 B1

Table 3.

(alloy components for the clad thin sheet material: inner side sacrificial material)

| | core material | | | | | | sacrificial material on passage side | | | | | | brazing filler metal on the opposite side from the passage | |
|---|---|---|---|---|---|---|---|---|---|---|---|---|---|---|
| | Mn | Cu | Si | Fe | Ti | Zr | Zn | Si | Fe | Mn | Ti | Zr | present/absent | Si |
| | 0.4-1.5 | 0.05-0.8 | 0.05-1.0 | 0.05-0.5 | 0.05-0.20 | 0.05-0.15 | 0.5-5.0 | 0.05-1.0 | 0.05-0.5 | 0.05-1.1 | 0.05-0.20 | 0.05-0.15 | | 6.5-12.6 |
| Example 9 | 0.42 | 0.78 | 0.06 | 0.43 | 0.1 | 0.1 | 0.8 | 1 | 0.07 | 1 | 0.05 | | present | 10.0 |
| 10 | 0.85 | 0.6 | 0.13 | 0.21 | | | 1.8 | 0.06 | 0.19 | 0.7 | | 0.05 | present | 10.0 |
| 11 | 1.1 | 0.5 | 0.24 | | | | 3.5 | 0.7 | 0.34 | 0.5 | 0.15 | | present | 9.5 |
| 12 | 1.2 | 0.5 | 0.25 | | 0.19 | | 4.7 | 0.3 | 0.3 | 0.05 | 0.1 | 0.14 | present | 5.3 |
| Comp. Example 6 | 1.3 | 0.12 | 0.4 | | 0.07 | | 0.2* | 0.3 | 0.2 | 0.3 | | | present | 9.0 |
| 7 | 1.3 | 0.12 | 0.4 | | 0 07 | | 5.5* | 0.3 | 0.2 | | 0.1 | 0.1 | present | 10.0 |

(inner fin composition)

| | core material | | | | | | | brazing filler metal | | |
|---|---|---|---|---|---|---|---|---|---|---|
| | Mn | Zn | Cu | Si | Fe | Ti | Zr | both sides one side absent | Si | Zn |
| | 0.8-1.5 | 0.5-3.0 | 0.05-0.3 | 0.05-1.0 | 0.05-0.5 | 0.05-0.20 | 0.05-0.15 | | 5.0-12.0 | 0.5-3.0 |
| A | 1.2 | 0.6 | | | | 0.05 | | both sides | 6.7 | 1.5 |
| B | 0.9 | 2.5 | | 0.96 | 0.34 | 0.12 | | one side | 11.5 | 2.7 |
| C | 1.4 | 2.8 | 0.29 | 0.34 | 0.19 | | 0.1 | none | | |

(composition: mass%)

EP 2 741 889 B1

Table 4.

| | annealing | | | strain production ratio, rolling ratio | | supplementary annealing | elongation | core material grain diameter | Si grain diameter | core material ratio after braziang |
|---|---|---|---|---|---|---|---|---|---|---|
| | temperature rise | temperature | condition | (%) | | | (%) | (μm) | (μm) | (%) |
| | 100 to 10,000°C/min | 300 to 550°C | 1 s to 4h | 3 to 25% (rolling for 10% or more) | | | % ≥ 10% | 10 to 100 μm | < 1.8 μm | ≥ 85% |
| Example 1 | 120 | 300 | 3.8 h | 3 | | | 23 | 95 | 1.7 | 88 |
| Example 2 | 800 | 340 | 20 min | 11 | | | 20 | 78 | 1.5 | 90 |
| Example 3 | 1,200 | 400 | 1 min | 15 | | | 15 | 65 | 1.7 | 92 |
| Example 4 | 1.200 | 450 | 10 s | 20 | | | 17 | 55 | 1.6 | 90 |
| Example 5 | 2.400 | 450 | 2 s | 12 | | | 20 | 43 | 1.3 | 93 |
| Example 6 | 2,480 | 500 | 10 s | 6 | | | 18 | 33 | 1.3 | 98 |
| Example 7 | 8,000 | 520 | 2 min | 24 | | | 12 | 19 | 1.2 | 92 |
| Example 8 | 9,600 | 400 | 28 s | 17 | | 180°C×7h | 16 | 12 | 1 | 95 |
| Example 9 (sacrificial) | 2.400 | 400 | 20 s | 23 | | | 11 | 45 | 1.4 | 90 |
| Example 10 (sacrificial) | 2,400 | 400 | 20 s | 29 | | 380°C × 1 h | 19 | 40 | 1.3 | 96 |
| Example 11 (sacrificial) | 3,600 | 400 | 14 s | 20 | | | 15 | 35 | 1.8 | 95 |
| Example 12 (sacrificial) | 3.600 | 300 | 3 h | 16 | | | 28 | 30 | 0.6 | 90 |
| Ref. Example 1 (Example 5) | * 50* | 400 | 1 min | 17 | | | 12 | 125* | 1.7 | 80* |
| Ref. Example 2 (Example 5) | 1,200 | 200* | 1 min | 17 | | | 8* | fiber | 1.5 | 70* |
| Ref. Example 3 (Example 5) | 200 | 550 | 5 h* | 17 | | | 14 | 86 | 2.2* | 88 |

EP 2 741 889 B1

| | annealing | | | strain production ratio, rolling ratio | supplementary annealing | elongation | core material grain diameter | Si grain diameter | core material ratio after braziang |
|---|---|---|---|---|---|---|---|---|---|
| | temperature rise | temperature | condition | (%) | | (%) | ($\mu$m) | ($\mu$m) | (%) |
| | 100 to 10,000°C/min | 300 to 550°C | 1 s to 4h | 3 to 25% (rolling for 10% or more) | | % $\geq$ 10% | 10 to 100 $\mu$m | < 1.8 $\mu$m | $\geq$ 85% |
| Ref. Example 4 (Example 5) | 2,400 | 400 | 1 min | 30* | | 8* | 34 | 15 | 88 |
| Ref. Example 5 (Example 5) | 2,400 | 450 | 2 s | 12 | 420°C × 6 h | 36 | 43 | 1.7 | 66* |
| Comp. Example 1 | 2,400 | 450 | 2s | 17 | | 16 | 43 | 1.7 | 90 |
| Comp. Example 2 | 9.600 | 400 | 1 min | 15 | | 20 | 14 | 1.3 | 90 |
| Comp. Example 3 | 2.400 | 400 | 1 min | 18 | | 16 | 30 | 1.7 | 90 |
| Comp. Example 4 | 2.400 | 400 | 1 min | 17 | | 15 | 14 | 1.6 | 83* |
| Comp. Example 5 | 3.600 | 400 | 1 min | 20 | | 12 | 40 | 1.7 | 90 |
| Comp. Example 6 | 2.400 | 400 | 1 min | 15 | | 18 | 40 | 1.6 | 93 |
| Comp. Example 7 | 2,400 | 400 | 1 min | 15 | | 18 | 43 | 1.5 | 92 |

EP 2 741 889 B1

Table 5.

| | potential difference | corrosion test flow rate | depth | evaluation | remarks |
|---|---|---|---|---|---|
| | ≥ 50 mV | (L/min) | (μm) | | |
| Example 1 | 55 | 10 | 130 | OK | |
| Example 2 | 60 | 10 | 180 | OK | |
| Example 3 | 100 | 10 | 90 | OK | |
| Example 4 | 120 | 10 | 100 | OK | |
| Example 5 | 150 | 15 | 88 | OK | |
| Example 6 | 180 | 20 | 190 | OK | |
| Example 7 | 150 | 30 | 140 | OK | |
| Example 8 | 220 | 10 | 120 | OK | |
| Example 9 (sacrificial) | 120 | 10 | 110 | OK | |
| Example 10 (sacrificial) | 200 | 10 | 115 | OK | |
| Example 11 (sacrificial) | 250 | 10 | 200 | OK | |
| Example 12 (sacrificial) | 290 | 10 | 221 | OK | |
| Ref Example 1 (Example 5) | 22 | 10 | leakage | NG | brazing capability NG (subgrains crystals remain due to retardation of recrystallization during brazing due to coarse core material crystal grains) |
| Ref. Example 2 (Example 5) | | | | | press molding NG (insufficient recrystallization due to low annealing temperature, low pre-brazing elongation) |
| Ref. Example 3 (Example 5) | 120 | 10 | 220 | — | laser welding supersolubility NG (long annealing time, coarsening of brazing filler metal Si grains) |
| Ref. Example 4 (Example 5) | 150 | | | | press forming NG (high rolling ratio, low pre-brazing elongation) |
| Ref. Example 5 (Example 5) | 150 | 15 | leakage | NG | brazing capability NG (high temperature in supplementary heat treatment after rolling, residual subgrains due to slow recrystallization → corrosion resistance NG) |
| Comp Example 1 | 23* | 10 | leakage | NG | leakage at the top sheet (deficient potential difference due to deficient Zn amount in brazing filler metal and deficient Mn amount in core material. core material ratio reduced due to increase in amount of Si on opposite side) |

(continued)

| | potential difference | corrosion test flow rate | depth | evaluation | remarks |
|---|---|---|---|---|---|
| | ≥ 50 mV | (L/min) | (μm) | | |
| Comp.Example 2 | 230 | 10 | leakage | NG | some problems with casting and rolling characteristics, leakage at joint regions (excess Mn in core material), leakage at joint regions (increased corrosion rate due to excess Zn in brazing filler metal) |
| Comp. Example 3 | 130 | 10 | 135 | NG | defective fin brazing (deficient amount of Si in the brazing filler metal) |
| Comp Example 4 | 45* | 10 | leakage | NG | leakage at the top sheet (excess Cu in core material, local melting during brazing, deficient potential difference, increased corrosion rate due to excess amount of Fe in the core material) |
| Comp. Example 5 | 38* | 10 | leakage | NG | leakage at the top sheet (deficient potential difference due to deficient Zn in the brazing filler metal), defective fin brazing (deficient amount of Si in the brazing filler metal) |
| Comp. Example 6 | 45* | 10 | leakage | NG | leakage at the top sheet (deficient potential difference due to deficient Zn in the sacrificial material) |
| Comp. Example 7 | 340 | 10 | leakage | NG | leakage at joints (preferential corrosion of joint regions due to excess Zn in the sacrificial material) |

Examples 1-8, Comparative Examples 1-5: inner fin C (refer to Table 3)

Examples 9-10, Comparative Example 6: inner fin B (refer to Table 3)

Examples 11-12, Comparative Example 7: inner fin A (refer to Table 3)

With the sample of Comparative Example 1, in which the Mn content of the clad thin sheet material was outside the range of the invention, adequate potential difference was not achieved and leakage occurred at the top sheet; with the sample of Comparative Example 2, leakage occurred at the joint regions; and with the sample of Comparative Example 3, which had a small Cu content, fin brazing was defective. With the sample of Comparative Example 4, which had a too large amount of Si in the passage side brazing filler metal, there was a problem with the press formability, adequate potential difference was not achieved, and leakage at the top sheet occurred, and with the sample of Comparative Example 5, in which the amount of Zn was low, leakage occurred at the top sheet due to defective brazing of the fin. With Comparative Examples 6 and 7, in which the amount of Zn in the passage side sacrificial material was either low or too high, leakage occurred at the top sheet or joint regions. Even in the case of structures that used the same materials as in Example 5, defects occurred, as given in Table 5, when any of the following were outside the range of the invention: the rate of temperature rise during annealing, the annealing temperature, the annealing time, the strain production ratio (rolling ratio), the elongation, the core material grain diameter, the average grain diameter of the Si grains, and the core material ratio after brazing (Reference Examples 1 to 5). In contrast to these samples, no defects occurred with the heat exchanger samples that satisfy the conditions of the invention.

The invention has been described with reference to example embodiments for illustrative purposes only. It should be understood that the description is not intended to be exhaustive or to limit form of the invention and that the invention may be adapted for use in other systems and applications.

**Claims**

1. A method of producing a cooler (10) for a heat-generating device comprising:

executing production of a tensile strain of 3 to 10% or a rolling process at a finish rolling ratio of 10 to 25% on a clad raw material that has a core material (21), a sacrificial material layer (22) that covers one side of the core material (21), and a brazing filler metal layer (24) that covers the other side of the core material (21), thereby obtaining a clad material (20) for a cooler (10); and

brazing the clad material (20) for a cooler (10) to other members that constitute the cooler, with the sacrificial material layer (22) side disposed on a fluid passage side, wherein:

the core material (21) is formed of an aluminum alloy that contains Mn, Cu, and Si in contents given below and contains at least one or two or more selected from Fe, Ti, and Zr in contents given below, with the balance being made of Al and unavoidable impurities

Mn : 0.4 to 1.5 mass%
Cu : 0.05 to 0.8 mass%
Si : 0.05 to 1.0 mass%
Fe : 0.05 to 0.5 mass%
Ti : 0.05 to 0.20 mass%
Zr : 0.05 to 0.15 mass%;

the sacrificial material layer (22) is formed of an Al alloy sacrificial material that contains Zn in a content given below and contains at least one or two or more selected from Si, Fe, Mn, Ti, and Zr in contents given below, with the balance being made of Al and unavoidable impurities

Zn : 0.5 to 5.0 mass%
Si : 0.05 to 1.0 mass%
Fe : 0.05 to 0.5 mass%
Mn : 0.05 to 1.1 mass%
Ti : 0.05 to 0.20 mass%
Zr : 0.05 to 0.15 mass%;

the brazing filler metal layer (24) is formed of an aluminum alloy brazing filler metal that contains Si in a content given below, with the balance being made of Al and unavoidable impurities

Si : 6.5 to 12.6 mass%;

prior to the brazing the clad material (20) for a cooler (10) to the other members that constitute the cooler (10), the clad material (20) for a cooler (10) has an elongation of at least 10%, an average crystal grain diameter of the core material (21) is 10 to 100 $\mu$m, and an average grain diameter, measured by equivalent circle diameter, of Si grains present in the brazing filler metal layer (24) is less than 1.8 $\mu$m, wherein the average crystal grain diameter of the core material and average grain diameter of the Si grains are determined by the measurement methods described in the description; and

after the brazing the clad material (20) for a cooler (10) to the other members that constitute the cooler, a potential difference between the core material (21) and a surface of the sacrificial material layer (22) is at least 50 mV and a proportion $t_1/T$ in %, of a thickness of the core material (21) to a total thickness of the clad material (20) for a cooler (10) satisfies the following Expression:

$t_i/T$ (%) $\geq$ 85% ... Expression

T : total thickness of the clad material (20) for a cooler (10)
$t_1$ : thickness of the core material (21) wherein the potential difference and the proportion $t_{1/}T$ are determined by the measurement methods described in the description.

2. The method of producing a cooler (10) for a heat-generating device according to claim 1, further comprising:
annealing the clad raw material (20), prior to the production of the 3 to 10% strain or the 10 to 25% finish rolling, by heating to a temperature within a range from 300°C to 550°C at a rate of temperature rise of 100 to 10,000°C/minute, keeping at the temperature for 1 second to 4 hours, and thereafter cooling.

3. The method of producing a cooler (10) for a heat-generating device according to claim 1 or 2, further comprising:
heat treating the clad raw material (20) by keeping for 1 to 8 hours at a temperature within a range from 150 to 400°C after the production of the 3 to 10% strain or after the 10 to 25% finish rolling.

4. A cooler (10) for a heat-generating device comprising:

- a top sheet (2) obtained by press-forming a clad material (20) which is obtained by executing production of a tensile strain of 3 to 10% or a rolling process at a finish rolling ratio of 10 to 25% on a clad raw material that has a core material (21), a sacrificial material layer (22) that covers one side of the core material (21), and a brazing filler metal layer (24) that covers the other side of the core material (21), wherein the core material (21) is formed of an aluminum alloy that contains Mn, Cu, and Si in contents given below and contains at least one or two or more selected from Fe, Ti, and Zr in contents given below, with the balance being made of Al and unavoidable impurities

Mn : 0.4 to 1.5 mass%
Cu : 0.05 to 0.8 mass%
Si : 0.05 to 1.0 mass%
Fe : 0.05 to 0.5 mass%
Ti : 0.05 to 0.20 mass%
Zr : 0.05 to 0.15 mass%;

the sacrificial material layer (22) is formed of an Al alloy sacrificial material that contains Zn in a content given below and contains at least one or two or more selected from Si, Fe, Mn, Ti, and Zr in contents given below, with the balance being made of Al and unavoidable impurities

Zn : 0.5 to 5.0 mass%
Si : 0.05 to 1.0 mass%
Fe : 0.05 to 0.5 mass%
Mn : 0.05 to 1.1 mass%
Ti : 0.05 to 0.20 mass%
Zr : 0.05 to 0.15 mass%;

and the brazing filler metal layer (24) is formed of an aluminum alloy brazing filler metal that contains Si in a content given below, with the balance being made of Al and unavoidable impurities

Si : 6.5 to 12.6 mass%; so that

prior to brazing the top sheet (2) to the other members of the cooler, the clad material (20) has an elongation of at least 10%, an average crystal grain diameter of the core material (21) is 10 to 100 $\mu$m, and an average grain diameter, measured by equivalent circle diameter, of Si grains present in the brazing filler metal layer (24) is less than 1.8 $\mu$m, wherein the average crystal grain diameter of the core material and average grain diameter of the Si grains are determined by the measurement methods described in the description; and

after brazing the top sheet (2) to the other members of the cooler, a potential difference between the core material (21) and a surface of the sacrificial material layer (22) is at least 50 mV and a proportion $t_1/T$ in %, of a thickness of the core material (21) to a total thickness of the clad material (20) satisfies the following Expression:

$$t_1/T \ (\%) \geq 85\% \qquad \ldots \qquad \text{Expression}$$

T : total thickness of the clad material (20)
$t_1$ : thickness of the core material (21) wherein the potential difference and the proportion $t_1/T$ are determined by the measurement methods described in the description,

- a bottom sheet (1) disposed so as to define a fluid passage (4) between the bottom sheet (1) and the top sheet (2), and having a sheet thickness greater than that of the top sheet (2); and
- an inner fin (3) held between the top sheet (2) and the bottom sheet (1), wherein
the top sheet (2), the bottom sheet (1), and the inner fin (3) are brazed to each other at their respective joint regions, and
the cooler (10) for a heat-generating device is configured to cool, by heat exchange with a coolant flowing within the fluid passage (4), a heat-generating device (7) that is attachable to the top sheet (2) on the side opposite from the fluid passage.

5. The cooler (10) for a heat-generating device according to claim 4, wherein
a cooling device substrate (6) to which the heat-generating device (7) is attachable is brazed to a surface of the top sheet (2) on the side opposite from the fluid passage (4).

**Patentansprüche**

1. Verfahren zum Herstellen eines Kühlers (10) für eine wärmeerzeugende Vorrichtung, umfassend:

Ausführen eines Hervorrufens einer Zugspannung von 3 bis 10 % oder eines Walzprozesses bei einem Fertigwalzverhältnis von 10 bis 25 % an einem plattierten Rohmaterial, das ein Kernmaterial (21), eine Opfermaterialschicht (22), die eine Seite des Kernmaterials (21) bedeckt, und eine Hartlot-Füllmetallschicht (24), welche die andere Seite des Kernmaterials (21) bedeckt, aufweist, wodurch ein plattiertes Material (20) für einen Kühler (10) erhalten wird, und

Hartlöten des plattierten Materials (20) für einen Kühler (10) an andere Elemente, die den Kühler bilden, wobei die Seite der Opfermaterialschicht (22) auf einer Fluiddurchgangsseite angeordnet ist, wobei:

das Kernmaterial (21) aus einer Aluminiumlegierung gebildet ist, die Mn, Cu und Si in den nachfolgend angegebenen Gehalten und mindestens ein oder zwei oder mehr ausgewählt aus Fe, Ti und Zr in den nachfolgend angegebenen Gehalten enthält, wobei der Rest aus Al und unvermeidbaren Verunreinigungen

Mn: 0,4 bis 1,5 Massen-%
Cu: 0,05 bis 0,8 Massen-%
Si: 0,05 bis 1,0 Massen-%
Fe: 0,05 bis 0,5 Massen-%
Ti: 0,05 bis 0,20 Massen-%
Zr: 0,05 bis 0,15 Massen-%

besteht,

die Opfermaterialschicht (22) aus einem Opfermaterial aus einer Al-Legierung gebildet ist, das Zn in einem nachfolgend angegebenen Gehalt enthält, und mindestens ein oder zwei oder mehr ausgewählt aus Si, Fe, Mn, Ti und Zr in den nachfolgend angegebenen Gehalten enthält, wobei der Rest aus Al und unvermeidbaren Verunreinigungen

Zn: 0,5 bis 5,0 Massen-%
Si: 0,05 bis 1,0 Massen-%
Fe: 0,05 bis 0,5 Massen-%
Mn: 0,05 bis 1,1 Massen-%
Ti: 0,05 bis 0,20 Massen-%
Zr: 0,05 bis 0,15 Massen-%

besteht,

die Hartlot-Füllmetallschicht (24) aus einem Hartlotfüllmetall aus einer Aluminiumlegierung gebildet ist, das Si in einem nachfolgend angegebenen Gehalt enthält, wobei der Rest aus Al und unvermeidbaren Verunreinigungen

Si: 6,5 bis 12,6 Massen-%

besteht,

vor dem Hartlöten des plattierten Materials (20) für einen Kühler (10) an die anderen Elemente, die den Kühler (10) bilden, das plattierte Material (20) für einen Kühler (10) eine Dehnung von mindestens 10 % aufweist, ein durchschnittlicher Kristallkorndurchmesser des Kernmaterials (21) 10 bis 100 $\mu$m beträgt und ein durchschnittlicher Korndurchmesser, gemessen durch den äquivalenten Kreisdurchmesser, von Si-Körnern, die in der Hartlot-Füllmetallschicht (24) vorhanden sind, weniger als 1,8 $\mu$m beträgt, wobei der durchschnittliche Kristallkorndurchmesser des Kernmaterials und der durchschnittliche Korndurchmesser der Si-Körner durch die in der Beschreibung beschriebenen Messmethoden bestimmt werden, und

nach dem Hartlöten des plattierten Materials (20) für einen Kühler (10) an die anderen Elemente, die den Kühler bilden, eine Potentialdifferenz zwischen dem Kernmaterial (21) und einer Oberfläche der Opfermaterialschicht (22) mindestens 50 mV beträgt und ein Verhältnis $t_1/T$ in % einer Dicke des Kernmaterials (21) zu einer Gesamtdicke des plattierten Materials (20) für einen Kühler (10) den folgenden Ausdruck erfüllt:

$t_1/T$ (%) $\geq$ 85 % ... Ausdruck
T: Gesamtdicke des plattierten Materials (20) für einen Kühler (10)
$t_1$: Dicke des Kernmaterials (21), wobei die Potentialdifferenz und das Verhältnis $t_1/T$ durch die in der Beschreibung beschriebenen Messmethoden bestimmt werden.

2. Verfahren zum Herstellen eines Kühlers (10) für eine wärmeerzeugende Vorrichtung nach Anspruch 1, ferner umfassend:
Tempern des plattierten Rohmaterials (20) vor dem Hervorrufen der Spannung von 3 bis 10 % oder des Fertigwalzens von 10 bis 25 % durch Erhitzen auf eine Temperatur in einem Bereich von 300 °C bis 550 °C bei einer Temperaturanstiegsrate von 100 bis 10.000 °C/Minute, wobei es 1 Sekunde bis 4 Stunden bei der Temperatur gehalten wird, gefolgt von Abkühlen.

3. Verfahren zum Herstellen eines Kühlers (10) für eine wärmeerzeugende Vorrichtung nach Anspruch 1 oder 2, ferner umfassend:
Wärmebehandeln des plattierten Rohmaterials (20) durch 1- bis 8-stündiges Halten bei einer Temperatur in einem Bereich von 150 bis 400 °C nach dem Hervorrufen der Spannung von 3 bis 10 % oder nach dem Fertigwalzen von 10 bis 25 %.

4. Kühler (10) für eine wärmeerzeugende Vorrichtung, umfassend:

- eine Deckplatte (2), die durch Pressformen eines plattierten Materials (20) erhalten wird, das durch Ausführen des Hervorrufens einer Zugspannung von 3 bis 10 % oder eines Walzprozesses bei einem Fertigwalzverhältnis von 10 bis 25 % an einem plattierten Rohmaterial erhalten wird, das ein Kernmaterial (21), eine Opfermaterialschicht (22), die eine Seite des Kernmaterials (21) bedeckt, und eine Hartlot-Füllmetallschicht (24), welche die andere Seite des Kernmaterials (21) bedeckt, aufweist, wobei das Kernmaterial (21) aus einer Aluminiumlegierung gebildet ist, die Mn, Cu und Si in den nachfolgend angegebenen Gehalten enthält und mindestens ein oder zwei oder mehr ausgewählt aus Fe, Ti und Zr in den nachfolgend angegebenen Gehalten enthält, wobei der Rest aus Al und unvermeidbaren Verunreinigungen
Mn: 0,4 bis 1,5 Massen-%
Cu: 0,05 bis 0,8 Massen-%
Si: 0,05 bis 1,0 Massen-%
Fe: 0,05 bis 0,5 Massen-%
Ti: 0,05 bis 0,20 Massen-%
Zr: 0,05 bis 0,15 Massen-%
besteht,
die Opfermaterialschicht (22) aus einem Opfermaterial aus einer Al-Legierung gebildet ist, das Zn in einem nachfolgend angegebenen Gehalt enthält, und mindestens ein oder zwei oder mehr ausgewählt aus Si, Fe, Mn, Ti und Zr in den nachfolgend angegebenen Gehalten enthält, wobei der Rest aus Al und unvermeidbaren Verunreinigungen
Zn: 0,5 bis 5,0 Massen-%
Si: 0,05 bis 1,0 Massen-%
Fe: 0,05 bis 0,5 Massen-%
Mn: 0,05 bis 1,1 Massen-%
Ti: 0,05 bis 0,20 Massen-%
Zr: 0,05 bis 0,15 Massen-%
besteht,
und die Hartlot-Füllmetallschicht (24) aus einem Hartlotfüllmetall aus einer Aluminiumlegierung gebildet ist, das Si in einem nachfolgend angegebenen Gehalt enthält, wobei der Rest aus Al und unvermeidbaren Verunreinigungen
Si: 6,5 bis 12,6 Massen-%
besteht, so dass
vor dem Hartlöten der Deckplatte (2) an die anderen Elemente des Kühlers das plattierte Material (20) eine Dehnung von mindestens 10 % aufweist, ein durchschnittlicher Kristallkorndurchmesser des Kernmaterials (21) 10 bis 100 $\mu$m beträgt und ein durchschnittlicher Korndurchmesser, gemessen durch den äquivalenten Kreisdurchmesser, von Si-Körnern, die in der Hartlot-Füllmetallschicht (24) vorhanden sind, weniger als 1,8 $\mu$m beträgt, wobei der durchschnittliche Kristallkorndurchmesser des Kernmaterials und der durchschnittliche Korndurchmesser der Si-Körner durch die in der Beschreibung beschriebenen Messmethoden bestimmt werden, und nach dem Hartlöten der Deckplatte (2) an die anderen Elemente des Kühlers eine Potentialdifferenz zwischen dem Kernmaterial (21) und einer Oberfläche der Opfermaterialschicht (22) mindestens 50 mV beträgt und ein Verhältnis $t_1/T$ in % einer Dicke des Kernmaterials (21) zu einer Gesamtdicke des plattierten Materials (20) den folgenden Ausdruck erfüllt:

$$t_1/T\ (\%) \geq 85\ \% \qquad \ldots \qquad \text{Ausdruck}$$

T: Gesamtdicke des plattierten Materials (20)

$t_1$: Dicke des Kernmaterials (21), wobei die Potentialdifferenz und das Verhältnis $t_1/T$ durch die in der Beschreibung beschriebenen Messmethoden bestimmt werden,

- eine Bodenplatte (1), die derart angeordnet ist, dass sie einen Fluiddurchgang (4) zwischen der Bodenplatte (1) und der Deckplatte (2) definiert und eine Plattendicke aufweist, die größer als die der Deckplatte (2) ist, und
- eine innere Rippe (3), die zwischen der Deckplatte (2) und der Bodenplatte (1) gehalten wird,

wobei

die Deckplatte (2), die Bodenplatte (1) und die innere Rippe (3) an ihren jeweiligen Verbindungsbereichen miteinander hartverlötet sind, und

der Kühler (10) für eine wärmeerzeugende Vorrichtung dazu ausgestaltet ist, durch Wärmeaustausch mit einem in dem Fluiddurchgang (4) fließenden Kühlmittel eine wärmeerzeugende Vorrichtung (7) zu kühlen, die an der dem Fluiddurchgang gegenüberliegenden Seite an der Deckplatte (2) anbringbar ist.

**5.** Kühler (10) für eine wärmeerzeugende Vorrichtung nach Anspruch 4, wobei

ein Kühlvorrichtungssubstrat (6), an dem die wärmeerzeugende Vorrichtung (7) anbringbar ist, an der dem Fluiddurchgang (4) gegenüberliegenden Seite an eine Oberfläche der Deckplatte (2) hartgelötet wird.

## Revendications

**1.** Procédé de fabrication d'un refroidisseur (10) pour un dispositif de génération de chaleur comprenant :

la réalisation d'une déformation de traction de 3 à 10% ou un processus de laminage à un taux de laminage de finition de 10 à 25% sur une matière première plaquée comprenant un matériau de noyau (21), une couche de matière sacrificielle (22) qui recouvre un côté du matériau de noyau (21), et une couche de métal d'apport de brasage (24) qui recouvre l'autre côté du matériau de noyau (21), de manière à obtenir un matériau de revêtement (20) pour un refroidisseur (10) ; et

le brasage du matériau de revêtement (20) pour un refroidisseur (10) sur d'autres éléments qui constituent le refroidisseur, avec le côté de couche de matière sacrificielle (22) disposé sur un côté de passage de fluide, selon lequel :

le matériau de noyau (21) est constitué d'un alliage d'aluminium qui contient du Mn, Cu, et Si dans des teneurs données ci-dessous et contient au moins un ou deux ou plus choisis parmi du Fe, Ti, et Zr dans des teneurs données ci-dessous, le reste étant composé d'Al et d'impuretés inévitables

Mn : 0,4 à 1,5 % en masse

Cu : 0,05 à 0,8 % en masse

Si : 0,05 à 1,0 % en masse

Fe : 0,05 à 0,5 % en masse

Ti : 0,05 à 0,20 % en masse

Zr : 0,05 à 0,15 % en masse ;

la couche de matière sacrificielle (22) est constituée d'une matière sacrificielle d'alliage d'Al qui contient du Zn dans une teneur donnée ci-dessous et contient au moins un ou deux ou plus choisi parmi du Si, Fe, Mn, Ti, et Zr dans des teneurs données ci-dessous, le reste étant composé d'Al et d'impuretés inévitables

Zn : 0,5 à 5,0 % en masse

Si : 0,05 à 1,0 % en masse

Fe : 0,05 à 0,5 % en masse

Mn : 0,05 à 1,1 % en masse

Ti : 0,05 à 0,20 % en masse

Zr : 0,05 à 0,15 % en masse ;

la couche de métal d'apport de brasage (24) est constituée d'un métal d'apport de brasage d'alliage d'aluminium qui contient du Si dans une teneur donnée ci-dessous, le reste étant composé d'Al et d'impuretés inévitables

Si : 6,5 à 12,6 % en masse ;

avant le brasage du matériau de revêtement (20) pour un refroidisseur (10) sur les autres éléments qui constituent le refroidisseur (10), le matériau de revêtement (20) pour un refroidisseur (10) a un allongement d'au moins 10%, un diamètre de grain de cristal moyen du matériau de noyau (21) est de 10 à 100 $\mu$m, et un diamètre de grain moyen, mesuré par le diamètre de cercle équivalent, des grains de Si présents dans la couche de métal d'apport de brasage (24) est inférieur à 1,8 $\mu$m, le diamètre de grain de cristal moyen du matériau de noyau et le diamètre de grain moyen des grains de Si étant déterminés par les méthodes de mesure décrites dans la description ; et

après le brasage du matériau de revêtement (20) pour un refroidisseur (10) sur les autres éléments qui constituent le refroidisseur, une différence de potentiel entre le matériau de noyau (21) et une surface de la couche de matière sacrificielle (22) est d'au moins 50 mV et une proportion de $t_1/T$, en % d'une épaisseur du matériau de noyau (21) sur une épaisseur totale du matériau de revêtement (20) pour un refroidisseur (10) satisfait l'expression suivante :

$$t_1/T \ (\%) \ \geq \ 85\% \ \dots \qquad \text{Expression}$$

T : épaisseur totale du matériau de revêtement (20) pour un refroidisseur (10)
$t_1$ : épaisseur du matériau de noyau (21), la différence de potentiel et la proportion $t_1/T$ étant déterminées par les méthodes de mesure décrites dans la description.

2. Procédé de fabrication d'un refroidisseur (10) pour un dispositif de génération de chaleur selon la revendication 1, comprenant en outre:
la recuisson du matériau de revêtement (20), avant la réalisation de la déformation de 3 à 10% ou le laminage de finition à 10 à 25%, par chauffage à une température dans une plage de 300°C à 550°C à un taux d'augmentation de température de 100 à 10000°C/minute, le maintien à la température pendant 1 seconde à 4 heures, et ensuite le refroidissement.

3. Procédé de fabrication d'un refroidisseur (10) pour un dispositif de génération de chaleur selon la revendication 1 ou 2, comprenant en outre:
Le traitement thermiquement du matériau de revêtement (20) par maintien pendant 1 à 8 heures à une température dans une plage de 150 à 400°C après la réalisation de la déformation de 3 à 10% ou après le laminage de finition à 10 à 25%.

4. Refroidisseur (10) pour un dispositif de génération de chaleur comprenant :

- une feuille supérieure (2) obtenue en formant à la presse un matériau de revêtement (20) qui est obtenue en réalisant une déformation de traction de 3 à 10% ou un processus de laminage à un rapport de laminage de finition de 10 à 25% sur une matière première plaquée qui a un matériau de noyau (21), une couche de matière sacrificielle (22) qui recouvre un côté du matériau de noyau (21), et une couche de métal d'apport de brasage (24) qui recouvre l'autre côté du matériau de noyau (21), le matériau de noyau (21) étant constitué d'un alliage d'aluminium qui contient du Mn, Cu, et Si dans des teneurs données ci-dessous et contient au moins un ou deux ou plus choisis parmi du Fe, Ti, et Zr dans des teneurs données ci-dessous, le reste étant composé d'Al et d'impuretés inévitables
Mn : 0,4 à 1,5 % en masse
Cu : 0,05 à 0,8 % en masse
Si : 0,05 à 1,0 % en masse
Fe : 0,05 à 0,5 % en masse
Ti : 0,05 à 0,20 % en masse
Zr : 0,05 à 0,15 % en masse ;
la couche de matière sacrificielle (22) est constituée d'une matière sacrificielle d'alliage d'Al qui contient du Zn dans une teneur donnée ci-dessous et contient au moins un ou deux ou plus choisi parmi du Si, Fe, Mn, Ti, et Zr dans des teneurs données ci-dessous, le reste étant composé d'Al et d'impuretés inévitables
Zn : 0,5 à 5,0 % en masse
Si : 0,05 à 1,0 % en masse
Fe : 0,05 à 0,5 % en masse
Mn : 0,05 à 1,1 % en masse
Ti : 0,05 à 0,20 % en masse
Zr : 0,05 à 0,15 % en masse ;
et la couche de métal d'apport de brasage (24) est constituée d'un métal d'apport de brasage d'alliage d'aluminium qui contient du Si dans une teneur donnée ci-dessous, le reste étant composé d'Al et d'impuretés inévitables
Si : 6,5 à 12,6 % en masse ; de telle sorte que

avant le brasage de la feuille supérieure (2) sur les autres éléments du refroidisseur, le matériau de revêtement (20) a un allongement d'au moins 10%, un diamètre de grain de cristal moyen du matériau de noyau (21) est de 10 à 100 $\mu$m, et un diamètre de grain moyen, mesuré par le diamètre de cercle équivalent, de grains de Si présents dans la couche de métal d'apport de brasage (24) est inférieur à 1,8 $\mu$m, le diamètre de grain de cristal moyen du matériau de noyau et le diamètre de grain moyen des grains de Si étant déterminés par les méthodes de mesure décrites dans la description ; et

après le brasage de la feuille supérieure (2) sur les autres éléments du refroidisseur, une différence de potentiel entre le matériau de noyau (21) et une surface de la couche de matière sacrificielle (22) est d'au moins 50 mV et une proportion de $t_1/T$, en %, d'une épaisseur du matériau de noyau (21) sur une épaisseur totale du matériau de revêtement (20) satisfait l'expression suivante :

$$t_1/T \ (\%) \ \geq 85\% \ \ldots \qquad \text{Expression}$$

T : épaisseur totale du matériau de revêtement (20)

$t_1$ : épaisseur du matériau de noyau (21), la différence de potentiel et la proportion ti/T étant déterminées par les méthodes de mesure décrites dans la description,

- une feuille inférieure (1) disposée de façon à définir un passage de fluide (4) entre la feuille inférieure (1) et la feuille supérieure (2), et ayant une épaisseur de feuille plus grande que celle de la feuille supérieure (2) ; et

- une ailette intérieure (3) maintenue entre la feuille supérieure (2) et la feuille inférieure (1),

la feuille supérieure (2), la feuille inférieure (1), et l'ailette intérieure (3) étant brasées l'une sur l'autre au niveau de leurs zones de jonction respectives, et

le refroidisseur (10) pour un dispositif de génération de chaleur est configuré pour refroidir, par échange de chaleur avec un agent de refroidissement qui s'écoule à l'intérieur du passage de fluide (4), un dispositif de génération de chaleur (7) qui peut être fixé sur la feuille supérieure (2) sur le côté opposé au passage de liquide.

5. Refroidisseur (10) pour un dispositif de génération de chaleur selon la revendication 4, dans lequel
un substrat de dispositif de refroidissement (6) sur lequel le dispositif de génération de chaleur (7) peut être fixé est brasé sur une surface de la feuille supérieure (2) sur le côté opposé au passage de fluide (4).

# F I G . 1

# F I G . 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010016295 A
- US 2011014494 A1
- US 2009020585 A1
- US 2009165901 A1